# EUROPEAN PATENT SPECIFICATION

(11) **EP 2 698 783 B1**
(45) Date of publication and mention of the grant of the patent: **26.04.2017**
(21) Application number: 13180243.1
(22) Date of filing: 13.08.2013
(51) Int. Cl.: G09G 3/3233, H01L 27/32

(54) **Organic light emitting diode display**
Organische lichtemittierende Diodenanzeige
Affichage à diode électroluminescente organique

(30) Priority: 14.08.2012 KR 20120089114
(43) Date of publication of application: 19.02.2014
(73) Proprietor: Samsung Display Co., Ltd., Gyeonggi-do (KR)
(72) Inventor: Kim, Yong-Jae, Yongin-City (KR); Lee, Hae-Yeon, Yongin-City (KR); Kim, Keum-Nam, Yongin-city (KR)
(74) Representative: Gulde & Partner

(56) References cited:
- EP-A1- 2 642 476
- US-A1- 2010 201 673
- US-A1- 2012 026 147
- US-A1- 2012 146 999

## Description

The described technology relates generally to an organic light emitting diode display.

### Description of the Related Art

An organic light emitting diode display includes two electrodes and an organic emission layer interposed therebetween, electrons injected from one electrode and holes injected from the other electrode are bonded to each other in the organic emission layer to form an exciton, and light is emitted while the exciton discharges energy.

The organic light emitting diode display includes a plurality of pixels, each including an organic light emitting diode that is a self-light emitting element, and a plurality of thin film transistors and capacitors for driving the organic light emitting diodes are formed in each pixel. Organic light emitting diode displays are known from US 2012/0026147 A1, US2012/146999 A1, US 2010/0201673 A1 and EP 2 642 476 A1.

One frame of the organic light emitting diode display includes a scanning period for programming data, and a light emitting period during which light is emitted according to the programmed data. However, as the organic light emitting diode display is enlarged and resolution is increased, a signal delay phenomenon of the organic light emitting diode display is increased. Accordingly, the scanning period and the light emitting period are not sufficiently ensured, thus, it is difficult to drive the organic light emitting diode display.

The above information disclosed in this Background section is only for enhancement of understanding of the background of the described technology and therefore it may contain information that does not form the prior art that is already known in this country to a person of ordinary skill in the art.

### SUMMARY OF THE INVENTION

The invention is defined in the independent claim 1. The described technology has been made in an effort to provide an organic light emitting diode display that is suitable for enlargement and high resolution.

An exemplary embodiment provides an organic light emitting diode display including: a substrate, scan lines transferring scan signals to pixels, compensation control lines simultaneously transferring compensation control signals to the pixels, operation control lines applying operation control signals to the pixels, data lines crossing the scan line and transferring data signals to the pixels and driving voltage lines transferring a driving voltage to the pixels, wherein each pixel comprises a switching thin film transistor connected to the respective scan line and the respective data line, a compensation thin film transistor and an initialization thin film transistor connected to the respective compensation control line, an operation control thin film transistor connected to the respective operation control line and the switching thin film transistor, a driving thin film transistor connected to the respective driving voltage line, an organic light emitting diode connected to a driving drain electrode of the driving thin film transistor, and a hold capacitor connected between an operation control source electrode of the operation control thin film transistor and an initialization gate electrode of the initialization thin film transistor. Each pixel further comprises: a storage capacitor connected between the driving voltage line and the operation control thin film transistor, and a compensation capacitor connected between the operation control thin film transistor and the driving gate electrode of the driving thin film transistor.

The hold capacitor includes a first hold condenser plate connected to a drain electrode of the switching thin film transistor, and a second hold condenser plate overlapping the first hold condenser plate and connected to the horizontal compensation control line.

The organic light emitting diode display is characterized in that the scan lines are formed on the substrate, wherein the compensation control lines, the operation control lines and the driving voltage lines are crossing the scan lines and wherein the compensation control lines include vertical compensation control lines formed in parallel to the data lines and horizontal compensation control lines connected to the vertical compensation control lines at crossing positions with the vertical compensation control lines.

The first hold condenser plate may be formed on the same layer as a switching semiconductor layer of the switching thin film transistor, and the second hold condenser plate may be formed on the same layer as the scan line.

The second hold condenser plate may protrude upward and downward from the horizontal compensation control line.

The horizontal compensation control line may include a gate metal layer and a transparent electrode layer sequentially laminated, and the second hold condenser plate may be formed of only a transparent electrode layer.

The vertical compensation control line may be formed on the same layer as the data line. The organic light emitting diode display may further include: a gate insulating layer formed on the first hold condenser plate, and an interlayer insulating layer covering the second hold condenser plate formed on the gate insulating layer, wherein the horizontal compensation control line is connected through a contact hole formed in the interlayer insulating layer to the vertical compensation control line.

The driving voltage line may include a vertical driving voltage line formed in parallel to the data line and a horizontal driving voltage line connected to the vertical driving voltage line at a crossing position with the vertical driving voltage line.

The operation control line may include a vertical operation control line formed in parallel to the data line and a horizontal operation control line connected to the vertical operation control line at a crossing position with the vertical operation control line.

The vertical operation control line may be formed on the same layer as the data line, and the horizontal operation control line may be formed on the same layer as the scan line.

According to an exemplary embodiment, in a simultaneous emission with active voltage (SEAV) type organic light emitting diode display that is suitable for high resolution and enlargement, a second hold condenser plate of a hold capacitor holding a data signal while an organic light emitting diode emits light can be connected to a vertical compensation control line to be used as a horizontal compensation control line, such that both the vertical compensation control line and the horizontal compensation control line can be formed to prevent occurrence of mura due to a signal delay.

Further, since the second hold condenser plate of the hold capacitor is used as the horizontal compensation control line, a separate horizontal compensation control line may not need to be formed, thus preventing deterioration of an opening ratio generated in the case where the separate horizontal compensation control line is formed.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is an equivalent circuit of one pixel of an organic light emitting diode display according to an exemplary embodiment;
FIG. 2 is a view schematically showing positions of a plurality of thin film transistors and capacitors in three pixels of the organic light emitting diode display according to the exemplary embodiment;
FIG. 3 is a specific layout view of one pixel of the organic light emitting diode display according to the exemplary embodiment;
FIG. 4 is a cross-sectional view of the organic light emitting diode display of FIG. 3, which is taken along line IV-IV; and
FIG. 5 is a cross-sectional view of the organic light emitting diode display of FIG. 3, which is taken along line V-V.

### DETAILED DESCRIPTION OF THE INVENTION

Hereinafter, the present invention will be described more fully hereinafter with reference to the accompanying drawings, in which exemplary embodiments of the invention are shown.

The drawings and description are to be regarded as illustrative in nature and not restrictive. Like reference numerals designate like elements throughout the specification.

Further, the size and thickness of each component shown in the drawings are arbitrarily shown for understanding and ease of description, but the present invention is not limited thereto.

In the drawings, the thickness of layers, films, panels, regions, etc., are exaggerated for clarity. In the drawings, for understanding and ease of description, the thickness of some layers and areas is exaggerated. It will be understood that when an element such as a layer, film, region, or substrate is referred to as being "on" another element, it can be directly on the other element or intervening elements may also be present.

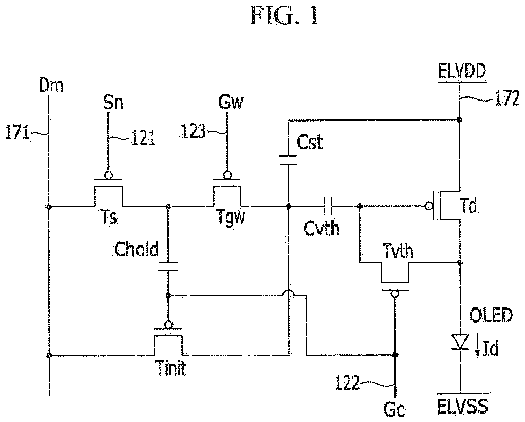

Then, an organic light emitting diode display according to an exemplary embodiment will be described in detail with reference to FIGS. 1 to 5.

FIG. 1 is an equivalent circuit of one pixel of an organic light emitting diode display according to an exemplary embodiment.

As shown in FIG. 1, one pixel of the organic light emitting diode display includes a plurality of signal lines 121, 122, 123, 171, and 172, and a plurality of thin film transistors Td, Ts, Tvth, Tinit, and Tgw, a plurality of capacitors Cst, Chold, and Cvth, and an organic light emitting diode OLED connected to a plurality of signal lines.

The plurality of thin film transistors includes a driving thin film transistor Td, a switching thin film transistor Ts, a compensation thin film transistor Tvth, an initialization thin film transistor Tinit, and an operation control thin film transistor Tgw. The plurality of capacitors includes a storage capacitor Cst, a hold capacitor Chold, and a compensation capacitor Cvth.

The signal lines include a scan line 121 transferring a scan signal Sn, a compensation control line 122 transferring a compensation control signal Gc to the compensation thin film transistor Tvth and the initialization thin film transistor Tinit, an operation control line 123 transferring an operation control signal Gw to the operation control thin film transistor Tgw, a data line 171 transferring a data signal Dm, and a driving voltage line 172 transferring a driving voltage ELVDD to the driving thin film transistor Td.

The gate electrode of the driving thin film transistor Td is connected to one end of the compensation capacitor Cvth, the source electrode of the driving thin film transistor Td is connected to the driving voltage line 172 and to one end of storage capacitor Cst, and the drain electrode of the driving thin film transistor Td is electrically connected to an anode of the organic light emitting diode OLED.

The gate electrode of the initialization thin film transistor Tinit is connected to the compensation control line 122 and to the hold capacitor Chold, the source electrode of the initialization thin film transistor Tinit is connected to the data line 171, and the drain electrode of the initialization thin film transistor Tinit is connected to another end of the compensation capacitor Cvth and to the drain electrode of the operation control thin film transistor Tgw. The initialization thin film transistor Tinit is turned on according to compensation control signal Gc transferred through the compensation control line 122. Then, the voltage of the gate electrode of the driving thin film transistar Td is initialized through the data line 171.

The gate electrode of the compensation thin film transistor Tvth is connected to the compensation control line 122, the source electrode of the compensation thin film transistor Tvth is connected to the drain electrode of the driving thin film transistor Td and to the anode of the organic light emitting diode OLED. The drain electrode of the compensation thin film transistor Tvth is connected to the one end of the compensation capacitor Cvth and to the gate electrode of the driving thin film transistor Td. The compensation thin film transistor Tvth is turned-on according to the compensation control signal Gc to connect the gate electrode and the drain electrode of the driving thin film transistor Td to each other, thus performing diode-connection of the driving thin film transistor Td.

A voltage corresponding to a threshold voltage of the driving thin film transistor Td is programmed in the compensation capacitor Cvth during a diode-connection period of the driving thin film transistor Td.

The gate electrode of the switching thin film transistor Ts is connected to the scan line 121, the source electrode of the switching thin film transistor Ts is connected to the data line 171, the drain electrode of the switching thin film transistor Ts is connected to another end of the holding capacitor Chold and to the source electrode of the operation control thin film transistor Tgw. The switching thin film transistor Ts is turned on according to the scan signal Sn and a scanning operation where the data signal Dm transferred from the data line 171 is programmed in the holding capacitor Chold is performed.

The gate electrode of the operation control thin film transistor Tgw is connected to the operation control line 123, the source electrode of the operation control thin film transistor Tgw is connected in common to the another end of the hold capacitor Chold and to the drain electrode of the switching thin film transistor Ts, and the drain electrode of the operation control thin film transistor Tgw is connected in common to the drain electrode of the initialization thin film transistor, to the another end of the compensation capacitor Cvth and to another end of the storage capacitor Cst.

The operation control thin film transistor Tgw is turned off while the organic light emitting diode OLED emits light. A data signal is programmed in the hold capacitor Chold during this period. That is, the operation control thin film transistor Tgw electrically blocks the hold capacitor Chold and the storage capacitor Cst from each other so that the light emission and data programming operations are simultaneously performed.

The data voltage transferred through the switching thin film transistor Ts turned on during a scanning period of an i-th frame is programmed in the hold capacitor Chold. The operation control thin film transistor Tgw is turned on during a period from at a time at which the light emitting period of the i-th frame is finished to a time at which the i+1-th light emitting period starts, and the data signal stored in the hold capacitor Chold is transferred to the storage capacitor Cst during a turn-on period.

One end of the storage capacitor Cst is connected in common to the driving voltage line 172 and to the source electrode of driving transistor Td, and a gate-source voltage of the driving transistor Td is determined according to a voltage programmed in the compensation capacitor Cvth and the storage capacitor Cst. The cathode of the organic light emitting diode OLED is connected to a common voltage ELVSS.

The organic light emitting diode OLED emits light according to a driving current Id transferred from the driving voltage ELVDD through the driving thin film transistor Td, and the driving current Id flows as a common voltage ELVSS.

As described above, the organic light emitting diode display according to the exemplary embodiment is operated according to a driving method where a plurality of pixels simultaneously emits light during a present frame period according to the data voltage programmed in a prior frame and present frame data are simultaneously programmed in a plurality of pixels.

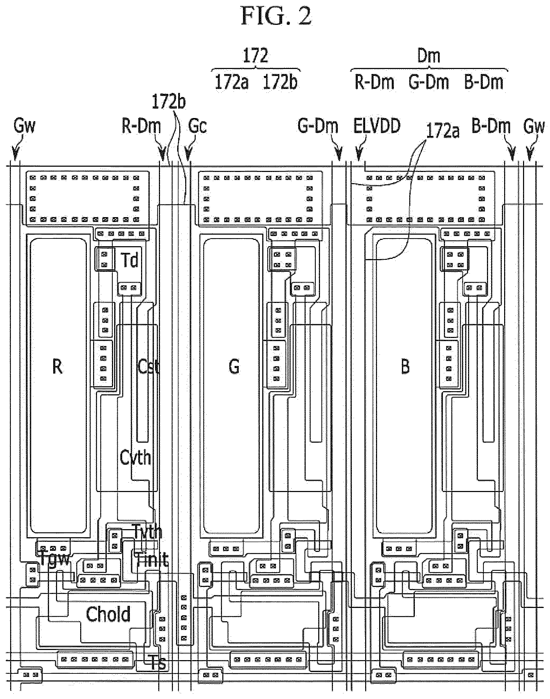

Then, a detailed structure of the pixel of the organic light emitting diode display shown in FIG. 1 will be described in detail with reference to FIGS. 2 to 5 together with FIG. 1.

FIG. 2 is a view schematically showing positions of a plurality of thin film transistors and capacitors in three pixels of the organic light emitting diode display according to the exemplary embodiment.

FIG. 2 is a view schematically showing positions three pixels, R (red) G (green) and B (blue) having, in particular, the plurality of thin film transistors and capacitors with respect to the R pixel, noting that the arrangement is similar with respect to the G and B pixels. Also shown are corresponding red, green and blue data signals R-Dm, G-Dm and B-Dm, respectively, as well as driving voltage lines 172a and 172b for applying the driving voltage ELVDD to the R, G and B pixels.

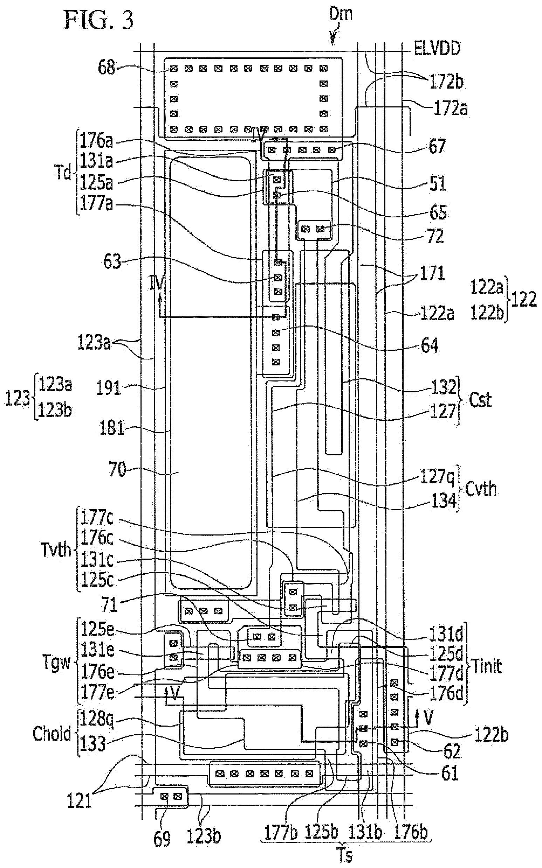

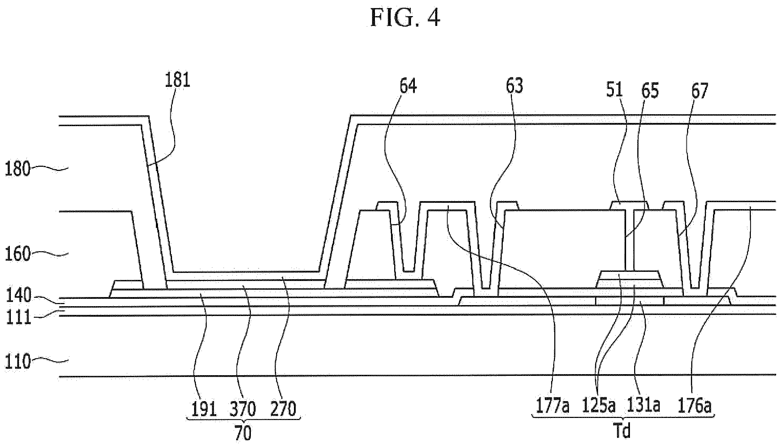

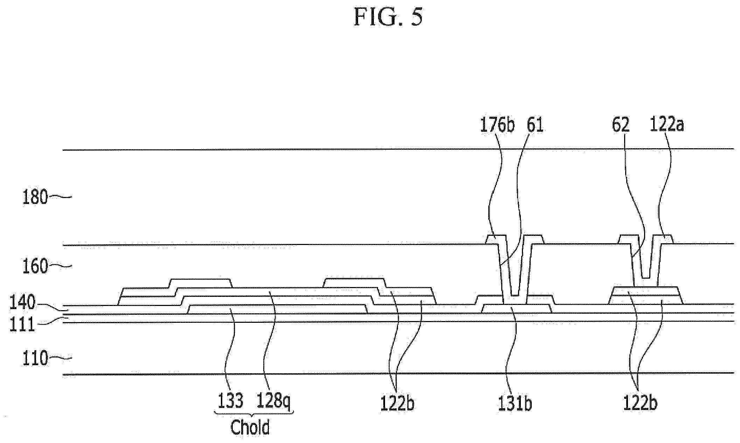

FIG. 3 is a specific layout view of one pixel of the organic light emitting diode display according to the exemplary embodiment, FIG. 4 is a cross-sectional view of the organic light emitting diode display of FIG. 3, which is taken along line IV-IV, and FIG. 5 is a cross-sectional view of the organic light emitting diode display of FIG. 3, which is taken along line V-V.

As shown in FIGS. 3 to 5, the pixel of the organic light emitting diode display according to the exemplary embodiment includes the scan line 121 transferring the scan signal Sn and formed in a row direction, the compensation control line 122 (122a, 122b) transferring the compensation control signal Gc and formed in a row direction and a column direction, the operation control line 123 (123a, 123b) transferring the operation control signal Gw and formed in a row direction and a column direction, and the data line 171 and the driving voltage line 172 (172a, 172b), crossing the scan line 121, the compensation control line 122, and the operation control line 123, and transferring the data signal Dm and the driving voltage ELVDD to the pixel, respectively.

The compensation control line 122 includes a vertical compensation control line 122a formed in parallel to the data line 171 and a horizontal compensation control line 122b connected to the vertical compensation control line 122a at a crossing position with the vertical compensation control line 122a, the operation control line 123 includes a vertical operation control line 123a formed in parallel to the data line 171 and a horizontal operation control line 123b connected to the vertical operation control line 123a at a crossing position with the vertical operation control line 123a, and the driving voltage line 172 includes a vertical driving voltage line 172a formed in parallel to the data line 171 and a horizontal driving voltage line 172b connected to the vertical driving voltage line 172a at a crossing position with the vertical driving voltage line 172a.

The data lines 171 transfer data signals Dm (R-Dm, G-Dm, and B- to three pixels, that is, a red pixel R, a green pixel G, and a red pixel B, respectively, as shown in FIG. 2), the driving voltage line 172 transfers the driving voltage ELVDD transferred through the vertical driving voltage line 172a to all the three pixels by using the horizontal driving voltage line 172b, the compensation control line 122 transfers the compensation control signal Gc transferred through the vertical compensation control line 122a to all the three pixels by using the horizontal compensation control line 122b, and the operation control line 123 transfers the operation control signal Gw transferred through the vertical operation control line 123a to all the three pixels by using the horizontal operation control line 123b.

Further, in the pixel, the driving thin film transistor Td, the switching thin film transistor Ts, the compensation thin film transistor Tvth, the initialization thin film transistor Tinit, the operation control thin film transistor Tgw, the storage capacitor Cst, the hold capacitor Chold, the compensation capacitor Cvth, and the organic light emitting diode 70 are formed.

The driving thin film transistor Td, the switching thin film transistor Ts, the compensation thin film transistor Tvth, the initialization thin film transistor Tinit, and the operation control thin film transistor Tgw are formed along the semiconductor layer 131, and the semiconductor layer 131 is bent to have various shapes. The semiconductor layer 131 is formed of polysilicon, and includes a channel region not doped with an impurity and a source region and a drain region formed at both sides of the channel region to be doped with the impurity. Herein, the impurity is changed according to a kind of thin film transistor, and an N type impurity or a P type impurity is feasible. The semiconductor layer includes a driving semiconductor layer 131a formed on the driving thin film transistor Td, a switching semiconductor layer 131b formed on the switching thin film transistor Ts, a compensation semiconductor layer 131c formed on the compensation thin film transistor Tvth, an initialization semiconductor layer 131d formed on the initialization thin film transistor Tinit, and an operation control semiconductor layer 131e formed on the operation control thin film transistor Tgw.

The driving thin film transistor Td includes the driving semiconductor layer 131a, the driving gate electrode 125a, the driving source electrode 176a, and the driving drain electrode 177a.

The switching thin film transistor Ts includes the switching semiconductor layer 131b, the switching gate electrode 125b, the switching source electrode 176b, and the switching drain electrode 177b. The switching drain electrode 177b corresponds to the switching drain region doped with the impurity in the switching semiconductor layer 131b.

The compensation thin film transistor Tvth includes the compensation semiconductor layer 131c, the compensation gate electrode 125c, the compensation source electrode 176c, and the compensation drain electrode 177c, and the compensation drain electrode 177c corresponds to a compensation drain region doped with the impurity in the compensation semiconductor layer 131c. The initialization thin film transistor Tinit includes the initialization semiconductor layer 131d, the initialization gate electrode 125d, the initialization source electrode 176d, and the initialization drain electrode 176e.

The operation control thin film transistor Tgw includes the operation control semiconductor layer 131e, the operation control gate electrode 125e, the operation control source electrode 176e, and the operation control drain electrode 177e, and the operation control source electrode 176e corresponds to an operation control source region doped with the impurity in the operation control semiconductor layer 131e.

The storage capacitor Cst includes a first storage condenser plate 132 and a second storage condenser plate 127 with the gate insulating layer 140 interposed therebetween. Herein, the gate insulating layer 140 is a dielectric material, and a storage capacitance is determined by charges accumulated in the storage capacitor Cst and a voltage between both condenser plates 132 and 127.

The first storage condenser plate 132 is formed on the same layer as the driving semiconductor layer 131a, the switching semiconductor layer 131b, the compensation semiconductor layer 131c, the initialization semiconductor layer 131d, and the operation control semiconductor layer 131e, and the second storage condenser plate 127 is formed on the same layer as the scan line 121.

A second compensation condenser plate 127q is connected through a contact hole 71 formed in an interlayer insulating layer 160 and a gate insulating layer 140 to the initialization drain electrode 177d and the operation control drain electrode 177e.

The hold capacitor Chold includes a first hold condenser plate 133 and a second hold condenser plate 128q with the gate insulating layer 140 interposed therebetween. The first hold condenser plate 133 is formed on the same layer as the semiconductor layer 131, and the second hold condenser plate 128q is formed on the same layer as the scan line 121.

The first hold condenser plate 133 is connected to the operation control source electrode 176e and the switch drain electrode 177b.

Hereinafter, referring to FIGS. 4 and 5, as well as referring back to FIG. 3, a structure of the organic light emitting diode display according to the exemplary embodiment will be described in detail according to the lamination order.

In this case, a structure of the thin film transistor will be described with the driving thin film transistor Td as a main part. Further, the residual thin film transistors Ts, Tvth, Tinit, and Tgw are mostly the same as the lamination structure of the driving thin film transistor Td, and thus are not described in further detail.

A buffer layer 111 is formed on the substrate 110, and the driving semiconductor layer 131a and the first hold condenser plate 133 forming the hold capacitor Chold are formed on the buffer layer 111. The substrate 110 is formed of an insulating substrate made of glass, quartz, ceramics, plastics, and the like.

A gate insulating layer 140 formed of silicon nitride (SiNx) or silicon oxide (SiO₂) is formed on the driving semiconductor layer 131a and the first hold condenser plate 133.

The scan line 121 including the switching gate electrode 125b, the horizontal compensation control line 122b including the compensation gate electrode 125c and the initialization gate electrode 125d, and the gate wire including the driving gate electrode 125a and the operation control gate electrode 125e are formed on the gate insulating layer 140. The gate wire further includes the second compensation condenser plate 127q forming the storage capacitor Cst and the compensation capacitor Cvth, the second hold condenser plate 128q forming the hold capacitor Chold, and the horizontal driving voltage line 172b. The second hold condenser plate 128q protrudes upward and downward from a portion of the horizontal compensation control line 122b.

The gate wire includes a gate metal layer and a transparent electrode layer sequentially laminated, accordingly, the driving gate electrode 125a and the horizontal compensation control line 122b include the gate metal layer and the transparent electrode layer sequentially laminated. In this case, the overlapping gate metal layer is removed for doping of the first hold condenser plate 133, thus forming the second hold condenser plate 128q by using only the transparent electrode layer. Further, the pixel electrode 191 connected to the driving thin film transistor Td is formed of only the transparent electrode layer because the overlapping upper gate metal layer is removed.

The interlayer insulating layer 160 covering the driving gate electrode 125a and the horizontal compensation control line 122b is formed on the gate insulating layer 140. The gate insulating layer 140 and the interlayer insulating layer 160 have a contact hole 63 through which a drain region of the driving semiconductor layer 131a is exposed together. The interlayer insulating layer 160, like the gate insulating layer 140, is made of a ceramic-based material such as silicon nitride (SiNx) or silicon oxide (SiO₂).

Data wires including the data line 171 including the switching source electrode 176b and the initialization source electrode 176d, the vertical driving voltage line 172a, the driving source electrode 176a, the driving drain electrode 177a, the compensation source electrode 176c, the vertical compensation control line 122a, the vertical operation control line 123a, and the connection member 51 are formed on the interlayer insulating layer 160.

Further, the switching source electrode 176b and the initialization source electrode 176d are connected through a contact hole 61 formed in the interlayer insulating layer 160 and the gate insulating layer 140 to a source region of the switching semiconductor layer 131b and a source region of the initialization semiconductor layer 131d, respectively.

The vertical driving voltage line 172a is connected through the contact hole 68 formed in the interlayer insulating layer 160 to the horizontal driving voltage line 172b, the vertical compensation control line 122a is connected through the contact hole 62 formed in the interlayer insulating layer 160 to the horizontal compensation control line 122b, and the vertical operation control line 123a is connected through the contact hole 69 formed in the interlayer insulating layer 160 to the horizontal operation control line 123b.

The driving source electrode 176a and the driving drain electrode 177a are connected through the contact holes 67 and 63 formed in the interlayer insulating layer 160 and the gate insulating layer to a source region and a drain region of the driving semiconductor layer 131a, respectively, the driving drain electrode 177a is connected through the contact hole 64 formed in the interlayer insulating layer 160 to the pixel electrode 191, and the connection member 51 is connected through the contact holes 65 and 72 formed in the interlayer insulating layer 160 to the driving gate electrode 125a and the first compensation condenser plate 134.

As described above, the vertical compensation control line 122a is connected through the contact hole 62 formed in the interlayer insulating layer 160 to the horizontal compensation control line 122b at a crossing position with the horizontal compensation control line 122b.

A plurality of compensation control lines 122 simultaneously transferring the compensation control signal Gc and the initialization signal Vinit is formed in a simultaneous emission with active voltage type organic light emitting diode display. However, in the case where a plurality of compensation control lines 122 is formed only in parallel to the data line 171, a difference in luminances occurs due to a signal delay between the compensation control line 122 that is close to an input terminal and the compensation control line 122 that is far from the input terminal among a plurality of compensation control lines 122, thus forming mura. That is, in the case where the data signal is applied through the data line 171, an end of the hold capacitor Chold is shaken, accordingly, a deviation to the original data signal may occur by a signal delay (RC delay) as going away from the input terminal of the compensation control line 122, thus forming the mura in a direction of the compensation control line 122. The compensation control line 122 may be formed in a mesh form in order to remove the mura, but in the case where the compensation control line 122 having the mesh form is formed, an opening ratio is reduced.

As described above, in the case where only a plurality of vertical compensation control lines 122a is formed, since the compensation control signals are divided at the input terminal of the vertical compensation control line 122a and transferred, a deviation in compensation control signals occurs between the input terminal of the vertical compensation control line 122a and the vertical compensation control line 122a formed at a position that is far therefrom due to the signal delay (RC delay) when the data signal is programmed, such that luminance of the pixel is made non-uniform.

However, in the organic light emitting diode display according to the exemplary embodiment, as shown in FIGS. 2 and 3, since both the vertical compensation control line 122a and the horizontal compensation control line 122b are formed, the deviation in the compensation control signal between the vertical compensation control lines 122a is alleviated by the horizontal compensation control line 122b, accordingly, luminances of all the pixels are made uniform.

That is, since the compensation control signal transferred through the vertical compensation control line 122a is transferred through even the horizontal compensation control line 122b, a signal delay phenomenon occurring in the pixel that is far from the input terminal of the vertical compensation control line 122a may be prevented. Accordingly, it is possible to prevent occurrence of the mura due to a reduction in luminance by the signal delay phenomenon.

Further, since the second hold condenser plate 128q of the hold capacitor Chold is used as the horizontal compensation control line 122b, a separate horizontal compensation control line 122 may not need to be formed, thus prevent deterioration of the opening ratio occurring in the case where the separate horizontal compensation control line 122 is formed.

The protective layer 180 covering the data wires 171, 172a, 176a, 177a, 176c, 122a, 123a, and 51 is formed on the interlayer insulating layer 160, and the pixel electrode 191 is exposed through an opening 181 formed in the protective layer 180. The pixel electrode 191 is connected through the contact hole 64 formed in the protective layer 180 to the driving drain electrode 177a.

An organic emission layer 370 is formed on the pixel electrode 191 exposed through the opening 181, and the common electrode 270 is formed on the organic emission layer 370. As described above, the organic light emitting diode 70 including the pixel electrode 191, the organic emission layer 370, and the common electrode 270 is formed.

Herein, the pixel electrode 191 is an anode that is a hole injection electrode, and the common electrode 270 is a cathode that is an electron injection electrode. However, the exemplary embodiment according to the present invention is not limited thereto, and the pixel electrode 191 may be the cathode and the common electrode 270 may be the anode according to the driving method of the organic light emitting diode display. Holes and electrons are injected from the pixel electrode 191 and the common electrode 270 into the organic emission layer 370, and when an exciton that is combined with the injected holes and electrons falls from an exited state to a bottom state, light is emitted.

The organic emission layer 370 may be formed of a low molecular weight organic material or a high molecular weight organic material. Further, the organic emission layer 370 may be formed of a multilayer including one or more of an emission layer, a hole injection layer HIL, a hole transport layer HTL, an electron transport layer ETL, and an electron injection layer EIL. In the case where all the layers are included, the hole injection layer HIL is disposed on the pixel electrode 191 that is the anode, and the hole transport layer HTL, the emission layer, the electron transport layer ETL, and the electron injection layer EIL are sequentially laminated thereon. Since the common electrode 270 is formed of a reflective conductive material, a rear surface light emission type organic light emitting diode display may be obtained. Material such as lithium (Li), calcium (Ca), lithium fluoride/calcium (LiF/Ca), lithium fluoride/aluminum (LiF/Al), aluminum (Al), silver (Ag), magnesium (Mg), or gold (Au) may be used as the reflective material.

## Claims

1. An organic light emitting diode display, comprising:
a substrate (110);
scan lines (121) transferring scan signals (Sn) to pixels;
compensation control lines (122) simultaneously transferring a compensation control signal (Gc) to the pixels;
operation control lines (123) applying operation control signals (Gw) to the pixels;
data lines (171) crossing the scan line (121) and transferring data signals (Dm) to the pixels and driving voltage lines (172) transferring a driving voltage (ELVDD) to the pixels; wherein each pixel comprises
a switching thin film transistor (Ts) connected to the respective scan line (121) and to the respective data line (171);
a compensation thin film transistor (Tvth) and an initialization thin film transistor (Tinit) connected to the respective compensation control line (122);
an operation control thin film transistor (Tgw) connected to the operation control line (123) and the switching thin film transistor (Ts);
a driving thin film transistor (Td) connected to the respective driving voltage line (172);
an organic light emitting diode (OLED) connected to a driving drain electrode of the driving thin film transistor (Td); and
a storage capacitor (Cst) connected between the driving voltage line (171) and the operation control thin film transistor (Tgw); and
a compensation capacitor (Cvth) connected between the operation control thin film transistor (Tgw) and the driving gate electrode (125a) of the driving thin film transistor (Td) and
a hold capacitor (Chold) connected between an operation control source electrode (176e) of the operation control thin film transistor (Tgw) and an initialization gate electrode (176d) of the initialization thin film transistor (Tinit),
wherein the hold capacitor (Chold) includes:
a first hold condenser plate (133) connected to a drain electrode of the switching thin film transistor (Ts); and
a second hold condenser plate (128q) overlapping the first hold condenser plate (133),
the organic light emitting diode display further **characterized in that**
the scan lines (121) are formed on the substrate, wherein the compensation control lines (122), the operation control lines (122) and the driving voltage lines (172) are crossing the scan lines (121) and wherein the compensation control lines (122) include vertical compensation control lines (122a) formed in parallel to the data lines (171) and horizontal compensation control lines (122b) connected to the vertical compensation control lines (122a) at crossing positions with the vertical compensation control lines (122a) and the second hold condenser plate (128q) of each pixel is connected to the respective horizontal compensation control line (122b).

2. The organic light emitting diode display of claim 1, wherein the first hold condenser plate (133) is formed on the same layer as a switching semiconductor layer (131b) of the switching thin film transistor (Ts), and the second hold condenser plate (128q) is formed on the same layer as the scan line (121).

3. The organic light emitting diode display of claim 1 or 2, wherein the second hold condenser plate (128q) protrudes upward and downward from the horizontal compensation control line (122b).

4. The organic light emitting diode display of one of claims 1 to 3, wherein the horizontal compensation control line (122b) includes a gate metal layer and a transparent electrode layer sequentially laminated, and the second hold condenser plate (128q) is formed of only a transparent electrode layer.

5. The organic light emitting diode display of one of the preceding claims, wherein the vertical compensation control line (122a) is formed on the same layer as the data line (171).

6. The organic light emitting diode display of one of claims 1 to 5, further comprising:
a gate insulating layer (140) formed on the first hold condenser plate (133); and
an interlayer insulating layer (160) covering the second hold condenser plate (128q) formed on the gate insulating layer (140), wherein the horizontal compensation control line (122b) is connected through a contact hole (62) formed in the interlayer insulating layer (160) to the vertical compensation control line (122a).

7. The organic light emitting diode display of one of the preceding claims, wherein the driving voltage line (172) includes a vertical driving voltage line (172a) formed in parallel to the data line (171) and a horizontal driving voltage line (172b) connected to the vertical driving voltage line (172a) at a crossing position with the vertical driving voltage line (172a).

8. The organic light emitting diode display of one of the preceding claims, wherein the operation control line (123) includes a vertical operation control line (123a) formed in parallel to the data line (171) and a horizontal operation control line (123b) connected to the vertical operation control line (123a) at a crossing position with the vertical operation control line (123a).

9. The organic light emitting diode display of claim 8, wherein the vertical operation control line (123a) is formed on the same layer as the data line (171), and the horizontal operation control line (123b) is formed on the same layer as the scan line (121).

## Patentansprüche

1. Organische lichtemittierende Diodenanzeige, aufweisend:
ein Substrat (110);
Ansteuerleitungen (121), die Ansteuersignale (Sn) zu Pixeln übertragen;
Ausgleichssteuerleitungen (122), die simultan ein Ausgleichssteuersignal (Gc) zu den Pixeln übertragen;
Betriebssteuerleitungen (123), die Betriebssteuersignale (Gw) an die Pixel anlegen;
Datenleitungen (171), die die Ansteuerleitung (121) kreuzen und Datensignale (Dm) zu den Pixeln übertragen, und Ansteuerspannungsleitungen (172), die eine Ansteuerspannung (ELVDD) zu den Pixeln übertragen; wobei jeder Pixel aufweist:
einen Schaltdünnfilmtransistor (Ts), der mit der jeweiligen Ansteuerleitung (121) und der jeweiligen Datenleitung (171) verbunden ist;
einen Ausgleichsdünnfilmtransistor (Tvth) und einen Initialisierungsdünnfilmtransistor (Tinit), die mit der jeweiligen Ausgleichssteuerleitung (122) verbunden sind;
einen Betriebssteuer-Dünnfilmtransistor (Tgw), der mit der Betriebssteuerleitung (123) und dem Schaltdünnfilmtransistor (Ts) verbunden ist;
einen Ansteuerdünnfilmtransistor (Td), der mit der jeweiligen Ansteuerspannungsleitung (172) verbunden ist;
eine organische lichtemittierende Diode (OLED), die mit einer Ansteuer-Drain-Elektrode des Ansteuerdünnfilmtransistors (Td) verbunden ist; und
einen Speicherkondensator (Cst), der zwischen die Ansteuerspannungsleitung (171) und den Betriebssteuer-Dünnfilmtransistor (Tgw) geschaltet ist; und
einen Ausgleichskondensator (Cvth), der zwischen den Betriebssteuer-Dünnfilmtransistor (Tgw) und die Ansteuer-Gate-Elektrode (125a) des Ansteuerdünnfilmtransistors (Td) geschaltet ist, und
einen Haltekondensator (Chold), der zwischen eine Betriebssteuer-Source-Elektrode (176e) des Betriebssteuer-Dünnfilmtransistors (Tgw) und eine Initialisierungs-Gate-Elektrode (176d) des Initialisierungsdünnfilmtransistors (Tinit) geschaltet ist,
wobei der Haltekondensator (Chold) aufweist:
eine erste Haltekondensatorplatte (133), die mit einer Drain-Elektrode des Schaltdünnfilmtransistors (Ts) verbunden ist; und
eine zweite Haltekondensatorplatte (128q), die die erste Haltekondensatorplatte (133) überlappt,
wobei die organische lichtemittierende Diodenanzeige ferner **dadurch gekennzeichnet ist, dass**
die Ansteuerleitungen (121) auf dem Substrat ausgebildet sind, wobei die Ausgleichssteuerleitungen (122), die Betriebssteuerleitungen (122) und die Ansteuerspannungsleitungen (172) die Ansteuerleitungen (121) kreuzen und wobei die Ausgleichssteuerleitungen (122) vertikale Ausgleichssteuerleitungen (122a), die parallel zu den Datenleitungen (171) ausgebildet sind, und horizontale Ausgleichssteuerleitungen (122b), die an Kreuzungspositionen mit den vertikalen Ausgleichssteuerleitungen (122a) mit den vertikalen Ausgleichssteuerleitungen (122a) verbunden sind, aufweisen, und wobei die zweite Haltekondensatorplatte (128q) jedes Pixels mit der jeweiligen horizontalen Ausgleichssteuerleitung (122b) verbunden ist.

2. Organische lichtemittierende Diodenanzeige nach Anspruch 1, wobei die erste Haltekondensatorplatte (133) auf derselben Schicht wie eine Schalthalbleiterschicht (131b) des Schaltdünnfilmtransistors (Ts) ausgebildet ist und die zweite Haltekondensatorplatte (128q) auf derselben Schicht wie die Ansteuerleitung (121) ausgebildet ist.

3. Organische lichtemittierende Diodenanzeige nach Anspruch 1 oder 2, wobei die zweite Haltekondensatorplatte (128q) von der horizontalen Ausgleichssteuerleitung (122b) nach oben und unten vorsteht.

4. Organische lichtemittierende Diodenanzeige nach einem der Ansprüche 1 bis 3, wobei die horizontale Ausgleichssteuerleitung (122b) eine Gate-Metallschicht und eine transparente Elektrodenschicht, die aufeinanderfolgend laminiert sind, aufweist, und die zweite Haltekondensatorplatte (128q) aus nur einer transparenten Elektrodenschicht ausgebildet ist.

5. Organische lichtemittierende Diodenanzeige nach einem der vorhergehenden Ansprüche, wobei die vertikale Ausgleichssteuerleitung (122a) auf derselben Schicht wie die Datenleitung (171) ausgebildet ist.

6. Organische lichtemittierende Diodenanzeige nach einem der Ansprüche 1 bis 5, ferner aufweisend:
eine Gate-Isolierschicht (140), die auf der ersten Haltekondensatorplatte (133) ausgebildet ist; und
eine Zwischenschicht-Isolierschicht (160), die die zweite Haltekondensatorplatte (128q), die auf der Gate-Isolierschicht (140) ausgebildet ist, bedeckt, wobei die horizontale Ausgleichssteuerleitung (122b) durch ein in der Zwischenschicht-Isolierschicht (160) ausgebildetes Kontaktloch (62) mit der vertikalen Ausgleichssteuerleitung (122a) verbunden ist.

7. Organische lichtemittierende Diodenanzeige nach einem der vorhergehenden Ansprüche, wobei die Ansteuerspannungsleitung (172) eine vertikale Ansteuerspannungsleitung (172a), die parallel zur Datenleitung (171) ausgebildet ist, und eine horizontale Ansteuerspannungsleitung (172b), die an einer Kreuzungsposition mit der vertikalen Ansteuerspannungsleitung (172a) mit der vertikalen Ansteuerspannungsleitung (172a) verbunden ist, aufweist.

8. Organische lichtemittierende Diodenanzeige nach einem der vorhergehenden Ansprüche, wobei die Betriebssteuerleitung (123) eine vertikale Betriebssteuerleitung (123a), die parallel zur Datenleitung (171) ausgebildet ist, und eine horizontale Betriebssteuerleitung (123b), die an einer Kreuzungsposition mit der vertikalen Betriebssteuerleitung (123a) mit der vertikalen Betriebssteuerleitung (123a) verbunden ist, aufweist.

9. Organische lichtemittierende Diodenanzeige nach Anspruch 8, wobei die vertikale Betriebssteuerleitung (123a) auf derselben Schicht wie die Datenleitung (171) ausgebildet ist und die horizontale Betriebssteuerleitung (123b) auf derselben Schicht wie die Ansteuerleitung (121) ausgebildet ist.

## Revendications

1. Dispositif d'affichage à diode électroluminescente organique, comprenant :
un substrat (110) ;
des lignes de balayage (121) transférant des signaux de balayage (Sn) à des pixels ;
des lignes de commande de compensation (122) transférant simultanément un signal de commande de compensation (Gc) aux pixels ;
des lignes de commande de fonctionnement (123) appliquant des signaux de commande de fonctionnement (Gw) aux pixels ;
des lignes de données (171) croisant la ligne de balayage (121) et transférant des signaux de données (Dm) aux pixels et des lignes de tension d'attaque (172) transférant une tension d'attaque (ELVDD) aux pixels ;
dans lequel chaque pixel comprend :
un transistor de commutation à couches minces (Ts) connecté à la ligne de balayage respective (121) et à la ligne de données respective (171) ;
un transistor de compensation à couches minces (Tvth) et un transistor d'initialisation à couches minces (Tinit) connectés à la ligne de commande de compensation respective (122) ;
un transistor de commande de fonctionnement à couches minces (Tgw) connecté à la ligne de commande de fonctionnement (123) et au transistor de commutation à couches minces (Ts) ;
un transistor d'attaque à couches minces (Td) connecté à la ligne de tension d'attaque respective (172) ;
une diode électroluminescente organique (OLED) connectée à une électrode drain d'attaque du transistor d'attaque à couches minces (Td) ;
un condensateur de stockage (Cst) connecté entre la ligne de tension d'attaque (172) et le transistor de commande de fonctionnement à couches minces (Tgw) ;
un condensateur de compensation (Cvth) connecté entre le transistor de commande de fonctionnement à couches minces (Tgw) et l'électrode grille d'attaque (125a) du transistor d'attaque à couches minces (Td) et
un condensateur de maintien (Chold) connecté entre une électrode source de commande de fonctionnement (176e) du transistor de commande de fonctionnement à couches minces (Tgw) et une électrode grille d'initialisation (176d) du transistor d'initialisation à couches minces (Tinit),
dans lequel le condensateur de maintien (Chold) comporte :
une première plaque de condensateur de maintien (133) connectée à une électrode drain du transistor de commutation à couches minces (Ts) ; et
une deuxième plaque de condensateur de maintien (128q) chevauchant la première plaque de condensateur de maintien (133) ;
le dispositif d'affichage à diode électroluminescente organique étant en outre **caractérisé en ce que**
les lignes de balayage (121) sont formées sur le substrat, où les lignes de commande de compensation (122), les lignes de commande de fonctionnement (123) et les lignes de tension d'attaque (172) croisent les lignes de balayage (121) et où les lignes de commande de compensation (122) comportent des lignes de commande de compensation verticales (122a) formées parallèlement aux lignes de données (171) et des lignes de commande de compensation horizontales (122b) connectées aux lignes de commande de compensation verticales (122a) à des positions de croisement avec les lignes de commande de compensation verticales (122a) et la deuxième plaque de condensateur de maintien du condensateur de maintien (Chold) de chaque pixel est connectée à la ligne de commande de compensation horizontale respective (122b).

2. Dispositif d'affichage à diode électroluminescente organique de la revendication 1, dans lequel la première plaque de condensateur de maintien (133) est formée sur la même couche qu'une couche semi-conductrice de commutation (131b) du transistor de commutation à couches minces (Ts), et la deuxième plaque de condensateur de maintien (128q) est formée sur la même couche que la ligne de balayage (121).

3. Dispositif d'affichage à diode électroluminescente organique de la revendication 1 ou 2, dans lequel la deuxième plaque de condensateur de maintien (128q) fait saillie vers le haut et vers le bas à partir de la ligne de commande de compensation horizontale (122b).

4. Dispositif d'affichage à diode électroluminescente organique de l'une des revendications 1 à 3, dans lequel la ligne de commande de compensation horizontale (122b) comporte une couche métallique de grille et une couche d'électrode transparente stratifiées séquentiellement, et la deuxième plaque de condensateur de maintien (128q) est formée uniquement d'une couche d'électrode transparente.

5. Dispositif d'affichage à diode électroluminescente organique de l'une des revendications précédentes, dans lequel la ligne de commande de compensation verticale (122a) est formée sur la même couche que la ligne de données (171).

6. Dispositif d'affichage à diode électroluminescente organique de l'une des revendications 1 à 5, comprenant en outre :
une couche d'isolation de grille (140) formée sur la première plaque de condensateur de maintien (133) ; et
une couche d'isolation intermédiaire (160) recouvrant la deuxième plaque de condensateur de maintien (128q) formée sur la couche d'isolation de grille (140), où la ligne de commande de compensation horizontale (122b) est connectée à travers un trou de contact (62) formé dans la couche d'isolation intermédiaire (160) à la ligne de commande de compensation verticale (122a).

7. Dispositif d'affichage à diode électroluminescente organique de l'une des revendications précédentes, dans lequel la ligne de tension d'attaque (172) comporte une ligne de tension d'attaque verticale (172a) formée parallèlement à la ligne de données (171) et une ligne de tension d'attaque horizontale (172b) connectée à la ligne de tension d'attaque verticale (172a) à une position de croisement avec la ligne de tension d'attaque verticale (172a).

8. Dispositif d'affichage à diode électroluminescente organique de l'une des revendications précédentes, dans lequel la ligne de commande de fonctionnement (123) comporte une ligne de commande de fonctionnement verticale (123a) formée parallèlement à la ligne de données (171) et une ligne de commande de fonctionnement horizontale (123b) connectée à la ligne de commande de fonctionnement verticale (123a) à une position de croisement avec la ligne de commande de fonctionnement verticale (123a).

9. Dispositif d'affichage à diode électroluminescente organique de la revendication 8, dans lequel la ligne de commande de fonctionnement verticale (123a) est formée sur la même couche que la ligne de données (171), et la ligne de commande de fonctionnement horizontale (123b) est formée sur la même couche que la ligne de balayage (121).
